# EUROPEAN PATENT SPECIFICATION

(11) **EP 1 388 019 B1**
(45) Date of publication and mention of the grant of the patent: **15.06.2005**
(21) Application number: 02743018.0
(22) Date of filing: 15.05.2002
(51) Int. Cl.: G02B 6/42, H05K 3/30, H01L 31/0203, H04B 10/158, H04N 7/22

(54) **DEVICE FOR ARRANGING A PHOTOELECTRIC TRANSDUCER AT AN ELECTRIC SIGNAL PROCESSING DEVICE**
VORRICHTUNG ZUM ANORDNEN EINES PHOTOELEKTRISCHEN WANDLERS AUF EINEM ELEKTRISCHEN SIGNALVERARBEITUNGSGERÄT
DISPOSITIF D'AGENCEMENT D'UN TRANSDUCTEUR PHOTOELECTRIQUE DANS UN DISPOSITIF DE TRAITEMENT DE SIGNAUX ELECTRIQUES

(30) Priority: 16.05.2001 US 291225 P
(43) Date of publication of application: 11.02.2004
(73) Proprietor: Motorola Broadband Nürnberg GmbH, 90441 Nürnberg (DE)
(72) Inventor: LEICHT, Günter, 96047 Bamberg (DE); GRAUVOGEL, Ulrich, 90451 Nürnberg (DE)
(74) Representative: Schröer, Gernot H., Dipl.-Phys.
(86) International application number: PCT/EP2002/005352
(87) International publication number: WO 2002/093222

(56) References cited:
- EP-A- 0 437 954
- WO-A-98/05058
- US-A- 5 361 318

## Description

The present invention relates to a device for arranging a photoelectric transducer at an electric signal processing device.

In cable television system (cable TV systems) television signals are transmitted from a cable television supplier or provider to a community of many different TV users via or through electrical coaxial cables or optical cables comprising glass fibers. In order to obtain a large bandwidth an optical transmission via optical cables or fibers is getting more and more common. But within the CATV communities themselves the already installed electrical coaxial cables in the buildings are still used. Therefore, the amplitude modulated (AM) optical television signals transmitted through the optical cables have to be converted into corresponding radio frequency (high frequency) electrical television signals by photoelectric (or: optoelectric, optoelectronic) transducers (or: converters) such as PIN photodetector diodes or other photodetectors.

The photoelectric transducer is fixedly connected to the end of a glass fiber for transmitting the optical signals to the optical input of the transducer. An electrical output of the photoelectric transducer is electrically connected to an electrical CATV amplifier for amplifying the converted electrical signals at the output of the transducer. The CATV amplifier contains active and passive electronic components arranged on a substrate such as a thick- or thin-film ceramic substrate or a printed circuit board (PCB) and a metal carrier body which the substrate is mounted onto and a protective cover or housing for protecting the substrate and the electronic components thereon. The metal carrier body is usually designed according to an international standard SOT215 and, accordingly, is of basically rectangular shape and of standardized dimensions.

The photoelectric transducer is mounted, directly or indirectly by means of a transducer carrier, onto the substrate and mechanically supported solely by the substrate. Furthermore, the electrical output of the transducer is electrically connected to the electronic circuits on the substrate. The glass fiber connected to the transducer is protected by a stiff rubber boot which is held fixedly and non-positively within an opening of the protective housing. The entire unit comprising the electrical amplifier and the mounted photoelectric transducer is also called an optical receiver module.

An optoelectronic transducer for use in a CATV optical receiver module is disclosed in US 5,627,531 A. This known optoelectronic transducer contains a photonic device such as a photodiode or a light emitting diode or laser fixed to a photonic device carrier of ceramic material and further contains a fiber carrier having a groove which an end portion of an optical single or multi mode fiber is mounted and fixed in by means of solder or adhesive. The fiber carrier is provided with a reflective surface and connected to the photonic device carrier in such a manner that the reflective surface is aligned with the optical fiber and the photonic device.

This known optoelectronic transducer can be used either for converting optical into electrical signals in the conventional cable TV application or for converting electrical into optical signals in modern interactive or bidirectional cable TV systems allowing for a signal transmission in the opposite direction from the TV user to the TV provider, the type of the encapsulated photonic device depending on the required signal direction.

A number of methods and devices are known in the art that are capable of mounting a photoelectric transducer to a substrate of a CATV amplifier.

It is known to mount the photoelectric transducer onto the substrate by soldering it to a mechanical metal clamp as a transducer carrier which in turn is soldered to the substrate.

Another particular method of mounting a photoelectric transducer to a substrate involves using an adhesive, such as one of UV-curable or thermosetting resins, for gluing the transducer to a plastic carrier and the carrier to the substrate.

Both known methods need no or only one extra part for the mounting of the transducer onto the CATV amplifier, are cheap and comply with standard technologies and, thus, are appreciated and well-established amongst those skilled in the art.

EP 0 437 954 A1 discloses an optical-electronic interface module having a printed circuit board (PC) as a substrate carrying electronic components, e.g. ICs, being carried by a base plate whose upwardly protruding pins are received within corresponding holes in the PC. A frame surrounding the substrate at its sides and a cover together form a housing for the PC on three sides, the housing being completed on the fourth lower side by the base plate. The PC substrate is folded upwardly and the cover keeps the folded PC from unfolding since the two triangularly folded flat parts of the PC rest at the cover. In a side wall of the frame a cylindrical hole is provided into which a metal receptacle is mounted carrying as a transducer carrier an optoelectronic transducer. Three leads of the transducer protrude into the space inside the frame. To keep the leads of the transducer as short as possible in order to avoid or minimize electromagnetic interference as well as to minimize distributed capacitances the printed circuit board has a tab folded upright in front of the cylindrical hole for the receptacle in the wall of the frame. The leads are cut to shorter stub length and then introduced in the corresponding holes in the tab and soldered to the patterned conductors on the tab of the conductive layer on the inner side of the tab and to the outer conductive layer serving as ground or shielding layer on the outside of the tab and of the whole PC. Only an insulating polyamide layer is arranged between the transducer and the ground layer and there is virtually no space between the transducer and the substrate. The frame as transducer carrier holder is mounted onto the base plate by gluing.

In US 5,361,318 A an optical module is disclosed comprising a substrate with electronics mounted on a substrate carrier. At a side wall with a cut out portion the photoelectric transducer is mounted laterally displaced to the substrate. Substrate and optoelectronic transducers are moulded into resin.

It is an object of the invention to provide, however, an alternative for arranging a photoelectric transducer at an electric signal processing device comprising a substrate carrying electronic components and/or circuits for signal processing and a substrate carrier carrying the substrate, in particular at a CATV or cable television amplifier.

This object and other objects are achieved, according to the invention, by the features of claim 1. The device according to claim 1 for arranging a photoelectric transducer at an electric signal processing device comprises a transducer carrying device into or onto which the photoelectric transducer is mountable or mounted and which is mounted or mountable directly onto the substrate carrier which carries the substrate of the signal processing device and preferably functions as a heat sink for deducting heat from the substrate and the electronic components thereon.

To use all space on the substrate and, by that, increase the degree of freedom within the electrical portion of the signal processing device, the design of the photoelectric transducer and of the transducer carrying device allows for the transducer to be mounted apart from the substrate or the signal processing device at a predetermined minimal distance sufficient for electronic components to be arranged beneath the transducer on the substrate.

In other words, according to the invention the photoelectric transducer, by means of the transducer carrying device connected to the substrate carrier, is mechanically supported solely by the substrate carrier and not by the substrate carrying the electronic components and/or circuits for the signal processing. The transducer carrying device serves as a sort of "mechanical interface" between the transducer and the substrate carrier. The substrate has no mechanical supporting function for the photoelectric transducer at all, contrary to all prior art solutions described already.

Since the transducer carrying device is mounted onto the substrate carrier rather than onto the substrate, as in the prior art, the danger of damage to the substrate during assembly of the photoelectric transducer onto or at the signal processing device is drastically reduced compared to the prior art.

Furthermore, whereas in the prior art considerable space for connecting the transducer or the transducer carrier to the substrate and usually also the glass fiber connected with the transducer has to be provided on the substrate, which space is lost for electronic circuits or components, the assembly according to the invention allows for extra space on the substrate which can be used for electronic components for signal processing and other electronic functions.

Now, in the technological development, the signal processing devices are to incorporate more and more functions and, on the other hand, the area available on a substrate carrier for the substrate and thus the size of the substrate remains limited in many applications, in particular when standards like the SOT115 standard have to be complied with. These somewhat contradicting objects are achieved by the features according to the invention which enable an increase of the capacity of the signal processing device and its electronic components compared to the prior art while, at the same time, not using any further space on the substrate.

Even if no additional electronic components or circuits are integrated on the substrate, the design of the circuits becomes nevertheless completely independent of the photoelectric transducer, enabling a higher degree of freedom within the electrical portion of the signal processing device and/or allowing for a standard design of the substrate for use in a purely electrical amplifier as well as in an optical receiver and/or several different designs of the substrates e.g. for different frequency bands.

A further advantage of the invention is the freedom of the positioning of the transducer itself which in turn does not depend upon the actual design of the substrate and can be chosen merely according to the needs for the arrangement of the transducer, its electrical connection and optimised optical connection to the glass fiber. The photoelectric transducer can be placed or positioned in any desired position at or in the proximity of the signal processing device simply by shaping and arranging the transducer carrying device accordingly.

In addition, the photoelectric transducer, in particular when equipped with the optical fiber, is quite sensitive to both mechanical and thermal stress. The assembly according to the invention does reduce the risk of damaging the sensitive transducer considerably since the transducer does not have to be subjected to thermal influences during its assembly as in the glueing or soldering process in the prior art.

When referring to the term "photoelectric" this includes the transformation of light or optical signals into electrical current or electrical signals as well as of electrical current or signals into light or optical signals. The terms "optical" or "light" include not only the visible spectrum but also the infrared spectrum.

Preferred embodiments and applications of the device invention are claimed in the dependent claims referring back to claim 1.

In general, the photoelectric transducer is electrically connected or connectable to the substrate by means of electrical connections, preferably by soldered and/or wire connection. These electrical connections do not fulfil any mechanical support function for the transducer. The photoelectric transducer is mechanically supported solely by the substrate carrier through the transducer carrying device and not by the substrate through the electrical connections therewith. In other words, the transducer would be firmly held in its relative position to the substrate even if the electrical connections were removed.

In a advantageous embodiment the substrate is arranged or fixed on or in a central portion of the substrate carrier and the transducer carrying device is connected or connectable to the substrate carrier in a portion of the substrate carrier which lies outside of or adjacent to the central portion.

For self-alignment of at least one pair of the components to be connected, in particular the transducer carrying device or the top cover and the substrate carrier and the transducer carrying device and the photoelectric transducer, the two components of a pair are provided with adjusting aids and/or with self-aligning connection means. Thus, the device in this embodiment does not need for use of additional handling or aligning tools.

In a preferred embodiment, the transducer carrying device is mounted onto the substrate carrier by means of at least one or a combination of the following connection means, namely pin-hole-connection, snapping means and clipping means. These types of connection means are in particular capable to align the transducer precisely with respect to the substrate.

In another preferred embodiment the transducer carrying device comprises a transducer carrier into or onto which the photoelectric transducer is mountable or mounted and a carrier holder which the transducer carrier is, preferably detachably (or: releasably, removably), securable (or: attachable, mountable, connectable) or secured (or: attached, mounted, connected) to. The carrier holder is connected or connectable with or to or onto the substrate carrier of the electrical signal processing device. Therefore, two additional parts are introduced to arrange the transducer at the signal processing means, namely the transducer carrier for carrying the transducer and the carrier holder for holding the transducer carrier.

This allows for a flexible mounting of the transducer and in particular of a light guide connected with the transducer since the transducer and/or the light guide can be either be detachable from the transducer carrier or permanently fixed to the transducer carrier or even also the carrier holder, for instance by glue, without fixing the optical components permanently to the substrate carrier.

The transducer carrier and the received or mounted transducer form a transducer unit which is mounted on or into the carrier holder and can, in one embodiment, be detached from the carrier holder easily. In case of a permanently assembled transducer unit the carrier holder can, in another embodiment, be designed removable from the substrate carrier. Therefore, in both embodiments, the transducer, with or without its transducer carrier, can be removed from the signal processing device which the carrier holder is mounted to or onto. Since the transducer is held and preferably protected by the transducer carrier and, in particular, the carrier holder the risk of damaging the transducer during the disassembly of the transducer unit and/or the carrier holder is significantly reduced.

In case either the signal processing device or the photoelectric transducer have to be replaced due to malfunction or damage the unit to be replaced can be separated from the intact unit and be replaced by a new unit. Those skilled in the art will appreciate that the material cost of the photoelectric transducer alone and even more together with the optical fiber usually integrated therein and the connector of the optical fiber is usually more than the material cost of a typical electronic signal processing device, in particular more than 1.5 times the material cost of an entire electrical CATV amplifier. Accordingly, the design according to this preferred embodiment allows for easily removing and reusing (or recycling) of a good transducer from a bad electrical signal processing device is clearly advantageous.

Furthermore, if a complete optoelectric device comprising the electric signal processing device and the optoelectric transducer unit has to be disposed of the different parts can be easily separated for recycling purposes.

The transducer is, in a preferred embodiment, detachably secured or securable to the transducer carrier, in particular by snapping or clipping means. Also the transducer carrier is secured or securable to the carrier holder preferably by snapping or clipping means.

Furthermore, the transducer carrying device or, in particular, the transducer carrier may comprise several holding sections (or: containment sections or fixing, stopping or limiting sections) in between of which the transducer is arranged and by which the transducer is substantially prevented from moving or falling out.

In an advantageous and preferred embodiment the device comprises a top cover, mounted or mountable onto or over the carrier holder or the transducer carrying device. After mounting the top cover and the carrier holder or the transducer carrying device together form a protective housing enclosing at least the transducer or the transducer carrier with the mounted transducer and preferably also the electronic circuits or the substrate. The top cover is preferably detachable from the transducer carrying device or the carrier holder.

In particular, the carrier holder or transducer carrying device can be provided with a transducer platform for mounting the transducer carrier or the transducer and a side wall surrounding the transducer platform and preferably also the substrate when the carrier holder or transducer carrying device is mounted on the substrate carrier. This side wall could provide the lower part of a housing wall while the, for instance box shaped, outer wall of the top cover may constitute an upper part of the housing wall.

In an advantageous embodiment the carrier holder or transducer carrying device, in particular the platform part, extends over the substrate allowing the mounted photoelectric transducer to be electrically connected easily to the signal processing device without using any space on the substrate.

The top cover is, in an advantageous embodiment, secured or connected to the substrate carrier too, preferably fixing or holding the carrier holder or transducer carrying device to or against the substrate carrier, in particular by non-positive connection and/or pin-hole-connection.

In order to remove the transducer from the electrical signal processing device the connection between the top cover and the substrate carrier can be broken or destroyed, for instance by drilling of the pins, without damaging the transducer within the top cover, and thereafter the top cover can be removed (and thrown away) and the transducer carrying device can be removed from the substrate carrier and be reused or recycled.

When the photoelectric transducer is equipped and optically connected with a light guide, in particular a glass fiber, the transducer carrying device and/or the transducer carrier and/or the carrier holder and/or the top cover may comprise a passage for the light guide with a passage wall protecting the light guide mechanically.

The light guide can, as already mentioned, in a specific embodiment be fixed within the transducer carrying device or the transducer carrier, in particular by glue, in order to reduce pull stress applied to the light guide, in particular from the transducer. To this purpose the transducer carrier is preferably provided with a hole, preferable in the passage wall, through or into which glue can be applied to fix the light guide at this point to the transducer carrier and, possibly, also to the carrier holder simultaneously.

For guiding the light guide and protecting it from mechanical stress and bending the top cover and the carrier holder or transducer carrying device comprise two corresponding cut-out sections forming, when mounted, an opening for the light guide. In this opening or in each of the cut-out sections preferably an elastic bearing part like a highly elastic, soft inlay body is arranged, the or both bearing parts forming a substantially loop- or ring-shaped bearing for the light guide within the opening. Preferably the elastic bearing provides a center of rotation for the light guide. This embodiment allows for maximum bend of the glass fiber without inducing damage to glass fiber during the assembly of the transducer and the signal processing device..

The preferred application of the device according to the invention is for or in an optoelectric "hybrid" device such as an optoelectric receiver or transmitter or combined optoelectric receiver and transmitter. The electrical signal processing device comprises preferably an electrical amplifier, in particular a CATV or cable television amplifier, wherein the substrate carrier is preferably designed according to SOT 115 standard.

The various features and advantages of the subject invention will be better understood by reference to the detailed description which follows taken in conjunction with the accompanying drawings, of which:
FIG 1 illustrates a mounting scheme for mounting a photoelectric transducer at a CATV amplifier in an exploded perspective (or: isometric) rear view,
FIG 2 shows a sequence of mounting steps for mounting the photoelectric transducer according to FIG 1 into its transducer carrier in a side view,
FIG 3 illustrates the transducer carrier with the mounted transducer after carrying out the mounting steps of FIG 2 in a perspective rear view,
FIG 4 illustrates the complete mounting scheme of FIG 1 after performance of the mounting steps of FIG 2 in an exploded rear view,
FIG 5 shows the transducer unit according to FIG 3 mounted onto the carrier in a perspective front view without the sidewall of the carrier holder,
FIG 6 illustrates a mounting scheme or assembly starting from FIG 4 after mounting of the transducer unit according to FIG 2 to 4 into the carrier holder and the carrier holder onto the CATV amplifier without the top cover in a perspective rear view,
FIG 7 shows the complete assembly resulting from that of FIG 5 and 6 by mounting the top cover and
FIG 8 shows a side view of the top cover and the carrier holder with the elastic bearing for the glass fiber in greater detail.

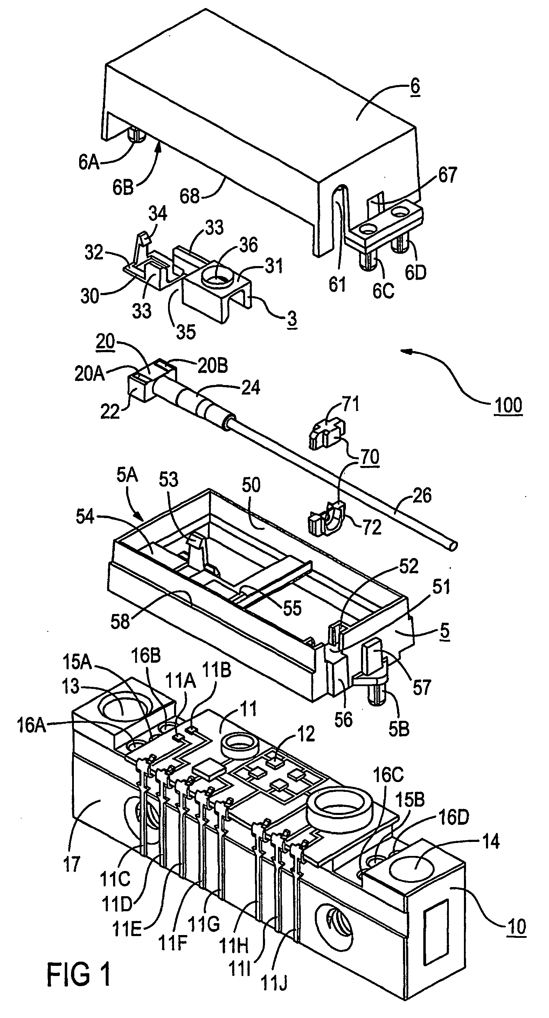

Like parts are designated by like reference symbols in FIG 1 through 8. It is worthy to note that any reference herein to "one embodiment" or "an embodiment" means that a particular feature, structure or characteristic described in connection with the embodiment is included in at least one embodiment of the invention. The appearances of the phrase "in one embodiment" in various places in the specification are not necessarily all referring to the same embodiment.

A conventional photoelectric transducer (or: photo detector) is designated by the reference numeral 20 and includes a body or housing containing a photodiode (or: photo detector diode) 22, in particular a PIN photo diode, a ferrule (or: holding sleeve) 24 and an end of a glass fiber (or any other light guide) 26 for transmitting optical or light signals to the photo diode 22 which converts these signals into electrical signals. The body with the enclosed photodiode 22 can be made of ceramic and preferably extends orthogonal to the ferrule 24 and glass fiber 26 so that a T- or hammer shaped structure of the photoelectric transducer 20 is obtained. On the top of the ceramic body with the photodiode 22 two electrical contacts 22A and 22B are arranged at a distance to each other which the photo voltage or current of the photodiode 22 can be detected at.

As a specific signal processing device a conventional cable television amplifier or CATV amplifier is shown and designated by the reference numeral 10 and comprises a, usually flat and often rectangular, substrate 11 and a substrate carrier body 17 carrying the substrate 11 and having dimensions according to the SOT115 international standard.

Electronic or electric signal processing and/or amplifying circuits 12 are arranged on the substrate 11, which can be formed as or by a printed circuit board or other printed substrate in thick or thin film technology. The amplifying circuits usually comprise differential cascode stage amplifier(s) equipped with Si or GaAs semiconducting devices, and/or integrated circuits. Also, electrical conductors are provided on the substrate 11 connecting the electronic circuits 12 with two electrical contacts 11A and 11B on the substrate 12 for connection to the corresponding contacts 20A and 20B of the photoelectric transducer 20 and several other electrical contacts 11C through 11K leading down at one side of the substrate carrier body 17 for signal input, signal output, battery (power supply) and ground connection.

The substrate carrier body 17 usually consists of metal or another material with good thermal conductivity in order to conduct heat generated by the operating electronic components or circuits 12 away from the substrate 11 and thus serves not only as a support but also as a heat sink or cooling body for the substrate 11. The - SOT115 shaped - substrate carrier body 17 has a symmetrical shape with two higher end or outer portions each having a screw hole 13 and 14 for screw connection to an amplifier housing (not shown) and a central portion which the substrate 11 is mounted onto. Between the end portions and the central portion two intermediate areas are formed adjacent to the central portion each containing an inner connection hole 15A and 15B and two outer connection holes 16A and 16B and 16C and 16D respectively. The distance of the two screw holes 13 and 14 is determined by the SOT115 standard.

In FIG 1 all parts of a preferred embodiment of a device for arranging the photoelectric transducer 20 at the signal processing device, i.e. the substrate 11 or the circuits 12 of the amplifier 10, are shown in a yet unassembled state. The device comprises a transducer carrier 3 for carrying and holding the photoelectric transducer 20, a carrier holder 5 (or: frame cover, lower housing part) for carrying and securing the transducer carrier 3, a top cover (or: top housing part) 6 and an elastic bearing 70 for the glass fiber 26 consisting of an upper bearing part 71 and a lower bearing part 72.

The transducer carrier 3 has a front area 30 for receiving the ceramic body with the photodiode 22 and a rear area 31 for enclosing and protecting the glass fiber 26. The front area 30 of the transducer carrier 3 has a bottom section 32 which the ceramic body with the photodiode 22 is laid upon, two side sections (or: side walls) 33 as holding and/or adjusting aids which the ferrule 24 is led through and laterally limited by, a hook-shaped snapping element 34 at the front for snapping in and holding firmly the ceramic body with the photodiode 22 and an opening 35 for inserting the transducer 20 into the transducer carrier 3. The rear area 31 of the transducer carrier 3 has a passage for the glass fiber 26 having a wall which is closed but at the bottom and provided with two openings for the glass fiber 26 and, furthermore, with a glue hole 36 at the top for optional glueing and, thus, permanently fixing the introduced glass fiber 26 into the transducer carrier 3 and preferably also to the carrier holder 5 when mounted.

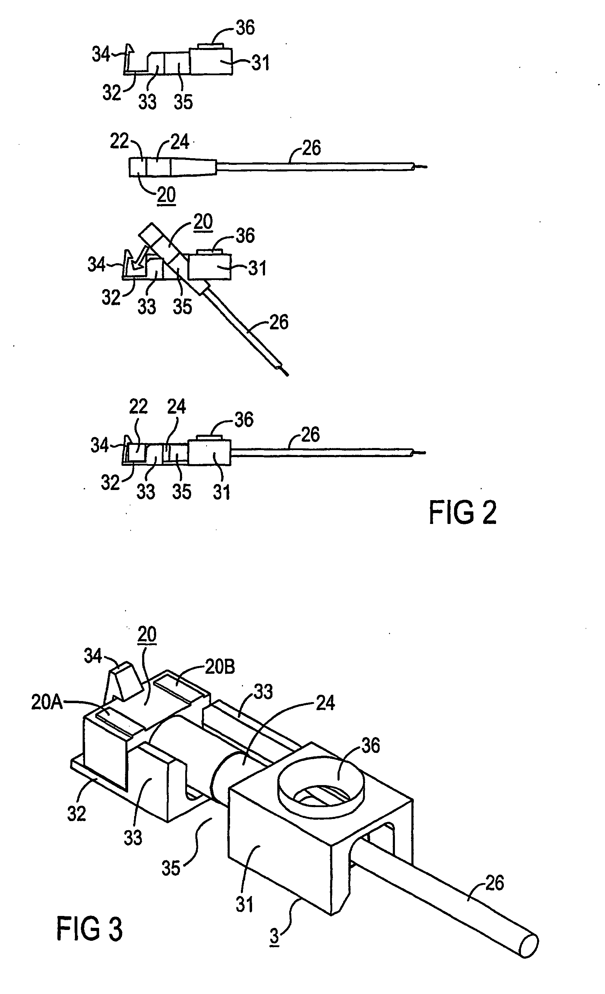

For mounting of the photoelectric transducer 20 into the transducer carrier 3 the photoelectric transducer 20 is introduced from below into the opening 35 of the bottom section 32 with the ceramic body containing the photodiode 22 first and the optical axis oriented orthogonal to the bottom section 32, as can be seen in FIG 2. Then, the photoelectric transducer 20 is rotated with the ceramic body and the photodiode 22 at its head towards the bottom section 32. The snapping element 34 is bent or deformed backwards and, subsequently, after the transducer 20 has passed it, snaps back by the elastic spring forces into a position resting, usually with a certain remaining spring pressure, on the ceramic body with the photodiode 22. At the same time, with this rotary movement, the optical glass fiber 26 is introduced from below into its passage in the rear area 31 of the transducer carrier 3.

The snapping element 34 also serves as a stop lug for stopping the ceramic body with the photodiode 22 and therefore the whole transducer 20 from moving to the front or upwardly. The front portions of the side sections 33 of the transducer carrier 3 serve as stops preventing a backward movement of the ceramic body with the photodiode 22 and thus the transducer 20. Together the snapping element 34 and the side section 33 form containment or holding sections for keeping the transducer 20 from falling out in any direction. The photoelectric transducer 20 is thus held firmly in the transducer carrier 3 and can be removed at any time by performing the steps shown in FIG 2 backwards.

FIG 3 shows the transducer unit resulting from the assembly according to FIG 2 with the transducer 3 mounted in the transducer carrier 3 in an isometric front view.

Returning to FIG 1, the carrier holder (or: frame cover) 5 is shaped as a rectangular frame, has a closed side wall 50 and a transducer platform 54 for the transducer carrier 3 at the bottom and next to the side wall 50 and is open, i.e. without a cover or roof, at the top. At the inner side of the transducer platform 54 at a distance from the side wall 50 a hook-shaped snapping element 53 is arranged extending upright from the bottom to the top of the carrier holder 5. At one end of the transducer platform 54 a crosspiece or bar 55 is extending in a perpendicular direction from the side wall 50. at the same long side of the side wall 50 as the transducer platform 54.

Axially disposed or parallel to this long side or the side wall 50 a cut-out section or opening (or: passage) 51 is formed in the shorter side of the side wall 50 orthogonal to the longer side. At the inner side behind this opening 51 a receiving portion 52 is formed within the carrier holder 5 by two vertical grooves and a bottom section for receiving the lower bearing part 72. Below the opening 51 a first adjusting aid 56 is formed protruding from the side wall 50 outwardly and vertically and a second adjusting aid 57 similar to the first one is formed at the same short side about in the middle.

At the two shorter sides of the side wall 50 two pins 5A and 5B (only 5B visible in FIG 1) are formed extending downwards parallel to the side wall 50 and jutting out from the rest of the carrier holder 5. These two pins 5A and 5B are formed in diameter and spaced apart in such a manner that they can be inserted simultaneously into the corresponding inner holes 15A and 15B in the substrate carrier body 17 in order to mount the carrier holder 5 onto the substrate carrier body 17 and, thus, onto amplifier 10.

The top cover 6 is shaped basically as a rectangular box to be arranged onto and/or around the carrier holder 5, thus forming a closed housing for protection of the transducer 3 wherein the top cover 6 forms the upper part and the carrier holder 5 the lower part of the housing. A longer side of the top cover 6 has a recessed edge 38 which is to be rested on a corresponding base 58 at the outside of the side wall 50 at the longer side of the carrier holder 5. For adjusting the relative position of the top cover 6 and the carrier holder 5 the top cover 6 has a longer opening 61 for receiving and guiding the first adjusting aid 56 of the carrier holder 5 and a shorter opening 67 for receiving and guiding the second adjusting aid 57. At the closed ceiling or top wall of the top cover 6 a receiving portion (not visible) similar to the receiving portion 52 in the carrier holder 5 is formed within the top cover 6 for receiving the upper bearing part 71.

At the shorter side walls of the top cover 6 two pins 6A and 6B and 6C and 6D are arranged respectively all extending downwardly and meant to be inserted into the outer connection holes 16A through 16D of the substrate carrier body 17 respectively for connecting the top cover 6 with or to the substrate carrier body 17.

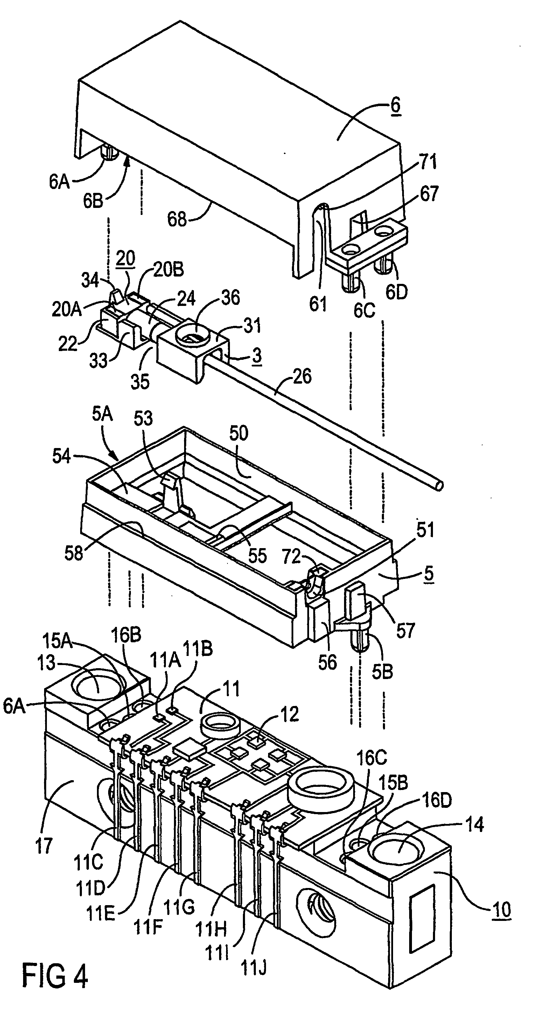

In FIG 4 the assembled transducer unit is shown in a rear view. Furthermore, in FIG 4 compared to the initial state shown in FIG 1, the lower bearing part 71 is already mounted into its corresponding receiving portion 51 in the carrier holder 5 and the other bearing part 72 is mounted into its corresponding receiving portion (not visible) in the top cover 6 behind the opening 61.

The photoelectric transducer 20 mounted in its transducer carrier 3 may now be removably mounted into or onto transducer platform 54 of the carrier holder 5 with the use of the snapping element 53 and the bar 55 serving as holding aids. To this purpose the snapping element 53 is bent backwards allowing the transducer carrier 3 to be snapped in and afterwards snaps back and rests on one of the side walls 33 with a certain remaining spring force. The transducer carrier 3 is thus fixed between the side wall 50 and the snapping element 54 laterally and between the side wall 50 and the bar 55 longitudinally or axially.

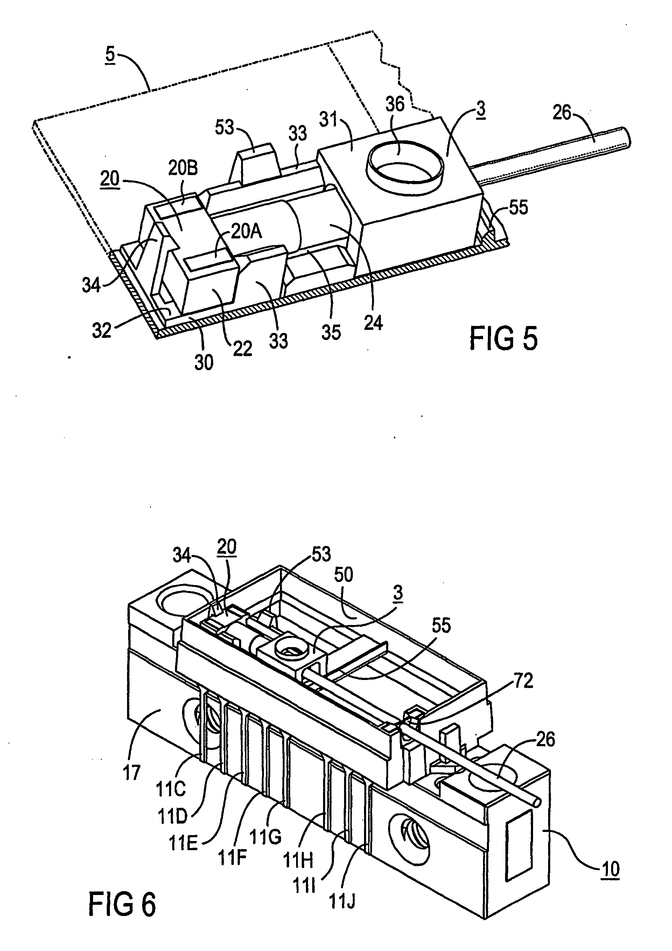

FIG 5 and 6 show the transducer carrier 3 held in such a manner in the carrier holder 5.

The holding aids (50, 53 and 55) of the transducer platform 54 and (33, 34) of the transducer carrier 3 allow the transducer 20 to be held and fixed with or without the use of a glue. If glue is not used, subsequent cure processes can be avoided, if a glue is used however, applied through glue hole 36, no additional tools are required for transducer alignment, i.e., to hold the transducer 20 in its position during the cure processes time interval.

Eventually, as shown in FIG 6, the carrier holder 5 with the mounted transducer carrier 3 is mounted onto the substrate carrier body 17 by inserting its pins 5A and 5B into the corresponding connection holes (or: blind holes) 15A and 15B and resting the carrier holder 5 with its rim portion on the upper surface of the substrate carrier body 17. The pins 5A and 5B have a diameter which is equal to or slightly smaller or bigger than the corresponding connection holes 15A and 15B so that the pins 5A and 5B just fit into the corresponding holes 15A and 15B and, thus, properly align the carrier holder 5 to the heat sink or substrate carrier body 17 and substrate 11.

Therefore, the carrier holder 5 may be easily taken or lifted off the substrate carrier body 17 if, for example, the amplifier 10 is defective and must be removed. The carrier holder 5 with the most valuable photoelectric transducer 20 is, in this case, pulled apart from the substrate carrier body 17 and may be reused in another good amplifier.

As shown in FIG 4 and 6, the photoelectric transducer 20 is now held at a distance determined by the carrier holder 5 above the substrate 12 and in particular above the electrical contacts 11A and 11B so that these contacts 11A and 11B can be easily connected to the contacts 20A and 20B of the photodiode 22. The glass fiber 26 of the photoelectric transducer 20 is held in the lower bearing part 72 and guided through the opening 51 in the carrier holder 5.

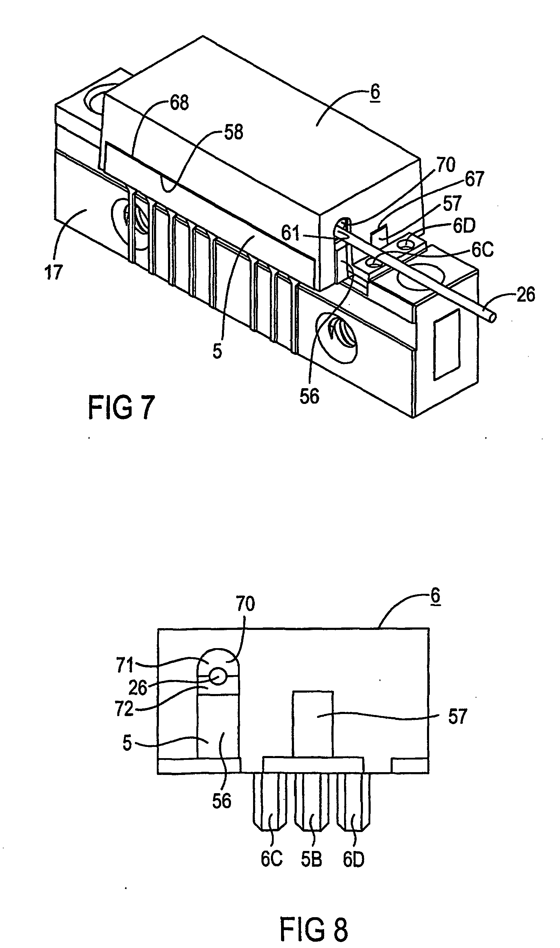

With reference to FIG 7 there is shown the completed mounting device assembly 100 with the top cover 6 mounted on top of the carrier holder 5 or frame cover. The carrier holder 5 incorporates the photoelectric transducer 20 assembled in the transducer carrier 3 (both not visible in FIG 7) which is snapped onto the transducer platform 54 (not visible in FIG 7) of the carrier holder 5, and the complete assembly is mounted to the substrate carrier body 17 and thus at the amplifier 10, in particular the amplifying circuits 12 on the substrate 11 in accordance with the present invention.

In FIG 8 this assembly according to FIG 7 is shown in a side view.

The mounted top cover 6 according to FIG 7 provides mechanical protection for the amplifier 10 and the circuits 12 on the substrate 11.

The top cover 6 according to FIG 7 and 8 is mounted onto and partly over the carrier holder 5. Top cover 6 fixes the carrier holder 5 tightly to the substrate carrier body 17 and holds or pins it down by means of the four pins 16A through 16D, which, contrary to the two pins 5A and 5B of carrier holder 5, are pressed tightly or non-positively into their corresponding blind holes 16A through 16D in the substrate carrier body 17.

In another embodiment the pins 5A and 5B of the carrier holder 5 can also be larger in diameter and be pressed into the blind or connection holes 15A and 15B of the substrate carrier body 17 for the purpose to "fix" the carrier holder 5.

The pins 5A, 5B and 6A through 6D are preferably hollow in order to obtain a spring force or sufficient deformation, especially for a non-positive connection with the corresponding blind holes.

In order to loosen one of the non-positive pin-hole connections it is convenient to destroy the pins 5A and 5B and/or 6A to 6D by use of a drilling tool or the like and then withdraw the whole part, i.e. the carrier holder 5 or top cover 6.

Thus, the assembly of FIG 7 can be disassembled in the reverse order very easily by drilling open the pins 6A through 6D, removing the top cover 6 and arriving at the state shown in FIG 6 again and so forth.

The apparatus or device according to FIG 1 to 7 provides the capability to remove or re-cycle the transducer 20 easily from the amplifier 10 with minimum risk for the transducer 20 and/or the glass fiber 26 to be damaged during this process. This is particularly advantageous since the transducer 20 and the glass fiber 26 are typically significantly more expensive than the remainder of the amplifier 10 (by approximately a factor of two to three). Accordingly, if the amplifier portion 10 of the optical receiver module is discovered to be defective, the transducer 20 together with the frame cover or carrier holder 5 can be removed from the defective amplifier 10 and can be easily reused in another amplifier.

In the embodiment shown in FIG 7 and 8 the cut-out portions or "pockets" or openings 51 and 61 in the carrier holder 5 and the top cover 6 collectively form a closed opening or passage for the glass fiber 26, i.e. a fiber exit gate.

Within this opening or fiber exit gate the two elastic bearing parts 71 and 72 collectively form a soft or flexible ring-shaped or closed bearing 70 for the glass fiber 26. The two elastic bearing parts 71 and 72 can be shaped as complementing semi-rings together forming an opening for the glass fiber 26, as shown in FIG 8, or one of the two bearing parts, in particular the lower bearing part 72, can receive the optical fiber 26 and the other bearing part 71 supports or supplements the first bearing part 72. The length of the contacting area or surface between the bearing 70 and the glass fiber 26 measured along the optical axis of the glass fiber 26 is in particular smaller than the diameter of the glass fiber 26, preferably by a factor of at least 2.

The closed elastic ring of the bearing 70 guides the glass fiber 26 and is the center of rotation for the glass fiber if bend stress is applied to it from outside the top cover 6 while the bending continues inside the top cover 6. Thus the two halves or bearing parts 71 and 72 of the rubber bearing 70 at the fiber exit gate operate together so as to provide a flexible fixation of the fiber such that if the glass fiber is bent away, for instance from the substrate carrier body 17, a center of rotation effect at the fiber exit gate is provided.

This flexible bearing 70 provides maximum tolerance to glass fiber bend during assembly of the optoelectric hybrid device. In other words, the elasticity or softness of the bearing 70 is so high that the glass fiber 26 is rotating around within and in the proximity of the bearing 70 if any bend stress is applied onto the glass fiber 26 outside of the top cover 6. Thus, the fiber is not fixed tightly by the bearing 70 but aligned in a center of rotation only. Accordingly, every bend of the glass fiber 26 outside the cover 5 and 6 allows the fiber 26 to move inside the cover 5 and 6 in a way, that the bend radius is minimized in any case, thus providing a significant risk reduction to damage the glass fiber 26 e.g. during the assembly of the optical receiver module.

Ideally a very soft material may be chosen as elastic material for the bearing 70, in particular a rubber or other elastomer with a module of elasticity typically between 1 and 10 N/mm² and/or a Share A value of typically 20, thereby allowing for a low force to be applied to the glass fiber 26 by the two rubber halves or rubber guides of the bearing parts 71 and 72.

The transducer carrier 3, the carrier holder 5 and/or the top cover 6 in all embodiments can be formed by integral plastic parts, in particular injection-moulded parts, allowing for a cheap production and great flexibility in shape and function..

The design according to the invention, in particular in the embodiments shown in FIG 1 to 8, provides the capability to align the transducer 20 precisely with respect to the substrate 11 without the need for use of additional handling tools.

Many modifications of the embodiments shown in FIG 1 through 8 are possible within the scope of the invention. For instance, instead of or in addition to the photodiode 22 a different photo detector or a photoelectric transducer converting electrical signals into light or optical signals could be provided, for instance a laser or laser diode or LED, and could be arranged at the signal processing device in a similar manner as the photodiode 22. This embodiment could, for example, be used in a bi-directional CATV system.

## Claims

1. Device for arranging a photoelectric transducer (20) at an electric signal processing device (10) having a substrate (11) carrying electronic components and/or circuits (12) for signal processing and a substrate carrier (17) carrying the substrate and preferably serving as a heat sink for the substrate, the device comprising
a transducer carrying device (3,5) into or onto which the photoelectric transducer (20) is mountable or mounted and which is mounted or mountable directly onto the substrate carrier,
wherein the transducer carrying device extends over and spaced apart from the substrate and wherein the photoelectric transducer is arranged above and spaced apart from the substrate at a predetermined minimal distance sufficient for electronic components to be arranged beneath the transducer on the substrate.

2. Device as claimed in claim 1, wherein the photoelectric transducer is electrically connected or connectable to the substrate by electrical connections (11A, 11B, 22A, 22B), preferably by soldered and/or wire connection.

3. Device as claimed in one of the preceding claims, wherein the transducer carrying device (3,4) is mounted onto the substrate carrier by means of at least one pin-hole-connection (5A,15A; 5B,15B) and/or by snapping means and/or by clipping means.

4. Device as claimed in one of the preceding claims, wherein the transducer carrying device is detachably mounted onto the substrate carrier and/or the photoelectric transducer is detachably mounted into or onto the transducer carrying device.

5. Device as claimed in one of the preceding claims, wherein the substrate is arranged on or in a central portion of the substrate carrier and the transducer carrying device is connected or connectable to the substrate carrier in an outer portion or a portion adjacent to the central portion of the substrate carrier.

6. Device as claimed in one of the preceding claims, wherein the transducer carrying device (3,4) comprises
a) a transducer carrier (3) into or onto which the photoelectric transducer (20) is, in particular detachably, mountable or mounted and
b) a carrier holder (5) into or onto which the transducer carrier (3) is, in particular detachably, mountable or mounted,
c) wherein said carrier holder is connectable or connected with or to the substrate carrier (17).

7. Device as claimed in any of the preceding claims, wherein the transducer carrying device or the transducer carrier comprises several holding sections (32, 33, 34) in between of which the transducer is placed and by which the transducer is substantially prevented from moving or falling out.

8. Device according to any of the preceding claims, wherein the transducer carrying device or the carrier holder comprises a transducer platform (54) for mounting the transducer carrier or the transducer and a side wall (50) surrounding the transducer platform and preferably also the substrate when the carrier holder or transducer carrying device is mounted on the substrate carrier

9. Device as claimed in any of the preceding claims further comprising a top cover (6), mounted or mountable onto or over the carrier holder and/or the transducer carrying device, the top cover and the carrier holder or transducer carrying device respectively together forming, when mounted, a housing at least for the photoelectric transducer or the transducer carrier with the mounted transducer and preferably also for the substrate.

10. Device as claimed in claim 9, wherein the top cover is, preferably non-positively, connected or connectable with or to the substrate carrier, in particular by means of at least one pin-hole-connection (6A to 6D, 16A to 16D), and wherein the top cover preferably fixes the carrier holder or the transducer carrying device to the substrate carrier.

11. Device as claimed in one of the preceding claims, wherein for self-alignment of at least one pair of the components to be connected, in particular the transducer carrying device or the top cover and the substrate carrier and the transducer carrying device and the photoelectric transducer, the components are provided with adjusting aids (e.g.. 56 und 61, 57 und 67) and/or with self-aligning connection means (e.g. 6C and 16C).

12. Device as claimed in any of the preceding claims, wherein the photoelectric transducer is optically connected with a light guide (26) which is preferably guided or guidable through at least one passage or opening (51, 61) in the transducer carrying device, the transducer carrier, the carrier holder and/or the top cover.

13. Device as claimed in claim 12, wherein the top cover and the transducer carrying device or the carrier holder comprise two corresponding cut-out sections (51, 61) together forming, when mounted, an opening for the light guide.

14. Device as claimed in claim 12 or 13, wherein within at least one passage or opening (51, 61) for the light guide (26) an elastic bearing (70) for the light guide is arranged, preferably providing a center of rotation for the light guide.

15. Optoelectric device comprising
a) at least one photoelectric transducer (20) for converting optical signals into electrical signals and/or electrical signals into optical signals,
b) an electric signal processing device (10) having
b1) a substrate (11) carrying electronic components and/or circuits (12) for electric signal processing and being electrically connected or connectable with the photoelectric transducer for transmitting electrical signals from the transducer to the electronic components or circuits and/or from the electronic components or circuits to the transducer and
b2) a substrate carrier (17) carrying the substrate and preferably serving as a heat sink for the substrate,
and further comprising
d) at least one device according to any of claims 1 to 14 for arranging the at least one photoelectric transducer (20) at the electric signal processing device (10), wherein each transducer carrying device (3, 5) carries at least one photoelectric transducer and each transducer carrying device is mounted directly onto the substrate carrier.

16. Optoelectric device as claimed in claim 15, wherein the photoelectric transducer is connected or connectable with a light guide (26) for transmitting optical signals to be converted or converted by the photoelectric transducer.

17. Optoelectric device as claimed in claim 15 or claim 16, wherein the electrical signal processing device comprises an electrical amplifier (10), in particular a cable television or CATV amplifier, and wherein the substrate carrier (17) is preferably designed according to SOT115 international standard.

## Patentansprüche

1. Vorrichtung zum Anordnen eines photoelektrischen Wandlers (20) an einer elektrischen Signalverarbeitungseinrichtung, welche ein Substrat (11), das elektronische Bauteile und/oder Schaltungen (12) zur Signalverarbeitung trägt, sowie einen Substratträger (17), welcher das Substrat trägt und vorzugsweise als Kühlkörper für das Substrat dient, aufweist, wobei die Vorrichtung folgendes umfasst:
eine Wandlerträgereinrichtung (3, 5), in welcher oder an welcher der photoelektrische Wandler (20) anbringbar bzw. angebracht ist, und
welche direkt auf dem Substratträger angebracht bzw. anbringbar ist, wobei sich die Wandlerträgereinrichtung über das Substrat erstreckt und von diesem beabstandet ist und der photoelektrische Wandler über dem Substrat von diesem in einem vorgegebenen minimalen Abstand beabstandet angeordnet ist, welcher zur Anordnung von elektronischen Bauelementen unter dem Wandler auf dem Substrat ausreicht.

2. Vorrichtung nach Anspruch 1, bei der der photoelektrische Wandler mittels elektrischer Verbindungen (11A, 11B, 22A, 22B), vorzugsweise mittels Löt- und/oder Drahtverbindungen, mit dem Substrat elektrisch verbunden bzw. verbindbar ist.

3. Vorrichtung nach einem der vorhergehenden Ansprüche, bei der die Wandlerträgereinrichtung (3, 4) mittels mindestens einer Stift-Loch-Verbindung (5A, 15A; 5B, 15B) und/oder mittels Schnappeinrichtung und/oder Steck- bzw. Klammereinrichtungen auf dem Substratträger angebracht ist.

4. Vorrichtung nach einem der vorhergehenden Ansprüche, bei der die Wandlerträgereinrichtung auf dem Substratträger lösbar angebracht ist und/oder der photoelektrische Wandler lösbar in oder an der Wandlerträgereinrichtung angebracht ist.

5. Vorrichtung nach einem der vorhergehenden Ansprüche, bei der das Substrat auf oder in einem Zentralbereich des Substratträgers angeordnet ist und die Wandlerträgereinrichtung in einem äußeren Bereich oder einem dem Zentralbereich des Substratträgers benachbarten Bereich mit dem Substratträger verbunden bzw. verbindbar ist.

6. Vorrichtung nach einem der vorhergehenden Ansprüche, bei der die Wandlerträgereinrichtung (3, 4) folgendes umfasst:
a) einen Wandlerträger (3), in dem bzw. an dem der photoelektrische Wandler (20), insbesondere lösbar anbringbar bzw. angebracht ist, und
b) einen Trägerhalter (5), in dem bzw. an dem der Wandlerträger (3) insbesondere lösbar anbringbar bzw. angebracht ist,
c) wobei der Trägerhalter mit dem Substratträger (17) verbindbar bzw. verbunden ist.

7. Vorrichtung nach einem der vorhergehenden Ansprüche, bei der die Wandlerträgereinrichtung bzw. der Wandlerträger mehrere Halteabschnitte (32, 33, 34) aufweist, zwischen denen der Wandler angeordnet ist und mit deren Hilfe eine Bewegung oder ein Herausfallen des Wandlers im Wesentlichen verhindert wird.

8. Vorrichtung nach einem der vorhergehenden Ansprüche, bei der die Wandlerträgereinrichtung bzw. der Wandlerträger eine Wandler-Plattform (54) zur Anbringung des Wandlerträgers bzw. des Wandlers sowie eine Seitenwandung (50) aufweist, welche die Wandler-Plattform und vorzugsweise auch das Substrat umgibt, wenn der Wandlerträger bzw. das die Wandlerträgereinrichtung auf dem Substratträger angebracht wird bzw. ist.

9. Vorrichtung nach einem der vorhergehenden Ansprüche, die des Weiteren eine obere Abdeckung (6) aufweist, die auf oder über dem Wandlerträger und/oder der Wandlerträgereinrichtung angebracht bzw. anbringbar ist, wobei die obere Abdeckung einerseits und der Trägerhalter oder die Wandlerträgereinrichtung andererseits zusammen im montierten Zustand ein Gehäuse zumindest für den photoelektrischen Wandler oder den Wandlerträger mit dem daran angebrachten Wandler und vorzugsweise auch für das Substrat bilden.

10. Vorrichtung nach Anspruch 9, bei der die obere Abdeckung mit dem Substratträger, vorzugsweise in nicht-formschlüssiger Weise, verbunden bzw. verbindbar ist, insbesondere mit Hilfe von mindestens einer Stift-Loch-Verbindung (6A bis 6D, 16A bis 16D), und bei der die obere Abdeckung vorzugsweise den Trägerhalter oder die Wandlerträgereinrichtung fest mit dem Substratträger verbindet.

11. Vorrichtung nach einem der vorhergehenden Ansprüche, bei der zur Selbstausrichtung von mindestens einem Paar der mit einander zu verbindenden Bauelemente, insbesondere der Wandlerträgereinrichtung oder der oberen Abdeckung und des Substratträgers sowie der Wandlerträgereinrichtung und des photoelektrischen Wandlers, die Bauelemente mit Einstellhilfen (zum Beispiel 56 und 61, 57 und 67) und/oder mit selbst-einstellenden Verbindungsmitteln (zum Beispiel 6C und 16C) versehen sind.

12. Vorrichtung nach einem der vorhergehenden Ansprüche, bei der der photoelektrische Wandler optisch mit einem Lichtleiter (26) verbunden ist, der vorzugsweise durch mindestens einen Durchlass bzw. eine Öffnung (51, 61) in der Wandlerträgereinrichtung, dem Wandlerträger, dem Trägerhalter und/oder der oberen Abdeckung geführt oder führbar ist.

13. Vorrichtung nach Anspruch 12, bei der die obere Abdeckung und die Wandlerträgereinrichtung bzw. der Trägerhalter zwei entsprechend ausgeschnittene Abschnitte (51, 61) aufweisen, welche zusammen im montierten Zustand eine Öffnung für den Lichtleiter bilden.

14. Vorrichtung nach Anspruch 12 oder 13, bei der innerhalb mindestens eines Durchlasses bzw. einer Öffnung (51, 61) für den Lichtleiter (26) eine elastische Lagerung (70) für den Lichtleiter angeordnet ist, welche vorzugsweise einen Drehmittelpunkt für den Lichtleiter bildet.

15. Optisch-elektrisches Bauelement, umfassend:
a) mindestens einen photoelektrischen Wandler (20) zum Umwandeln optischer Signale in elektrische Signale und/oder von elektrischen Signalen in optische Signale,
b) eine elektrische Signalverarbeitungseinrichtung (10), die folgendes umfasst:
b1) ein Substrat (11), welches elektronische Bauelemente und/oder Schaltungen (12) zur Verarbeitung elektrischer Signale trägt und dabei zur Übermittlung elektrischer Signale von dem Wandler zu den elektronischen Bauelementen bzw. Schaltungen und/oder von den elektronischen Bauelementen bzw. Schaltungen zu dem Wandler mit dem photoelektrischen Wandler elektrisch verbunden bzw. verbindbar ist, und
b2) einen Substratträger (17), welcher das Substrat trägt und vorzugsweise als Kühlkörper für das Substrat dient, und welches des Weiteren
d) mindestens eine Vorrichtung nach einem der Ansprüche 1 bis 14 zum Anordnen des mindestens einen photoelektrischen Wandlers (20) an der elektrischen Signalverarbeitungseinrichtung (10), wobei jede Wandlerträgereinrichtung (3, 5) mindestens einen photoelektrischen Wandler trägt und jede Wandlerträgereinrichtung direkt auf dem Substratträger angebracht ist, umfasst.

16. Optisch-elektrisches Bauelement nach Anspruch 15, bei dem der photoelektrische Wandler zur Übertragung von optischen Signalen, die von dem photoelektrischen Wandler umzuwandeln sind bzw. umgewandelt wurden, mit einem Lichtwellenleiter (26) verbunden bzw. verbindbar ist.

17. Optisch-elektrisches Bauelement nach Anspruch 15 oder Anspruch 16, bei dem die Signalverarbeitungseinrichtung einen elektrischen Verstärker (10), insbesondere einen Kabelfernseh-Verstärker bzw. CATV-Verstärker, aufweist und bei dem der Substratträger (17) vorzugsweise gemäß dem internationalen Standard SOT115 ausgelegt ist.

## Revendications

1. Dispositif d'agencement d'un transducteur photoélectrique (20) dans un dispositif de traitement de signaux électriques (10) présentant un substrat (11) portant des composants et/ou des circuits électroniques (12) pour traitement de signaux et un support de substrat (17) portant le substrat et servant de préférence de dissipateur de chaleur pour le substrat, le dispositif comprenant
un dispositif (3,5) portant le transducteur dans lequel ou sur lequel le transducteur photoélectrique (20) peut être monté ou est monté et qui est monté ou qui peut être monté directement sur le support de substrat,
dans lequel le dispositif portant le transducteur s'étend sur le substrat en étant écarté de celui-ci et dans lequel le transducteur photoélectrique est agencé au-dessus du substrat et écarté de celui-ci d'une distance minimale prédéterminée suffisante pour que des composés électroniques soient agencés en dessous du transducteur sur le substrat.

2. Dispositif tel que revendiqué dans la revendication 1, dans lequel le transducteur photoélectrique est relié électriquement ou peut être relié électriquement au substrat par des connexions électriques (11A, 11B, 22A, 22B), de préférence par connexion soudée et/ou câblée.

3. Dispositif tel que revendiqué dans l'une des revendications précédentes, dans lequel le dispositif (3,4) portant le transducteur est monté sur le support de substrat au moyen d'au moins une connexion à broche-trou (5A,15A;5B,15B) et/ou par des moyens d'encliquetage et/ou des moyens de clipsage.

4. Dispositif tel que revendiqué dans l'une des revendications précédentes, dans lequel le dispositif portant le transducteur est monté de manière amovible sur le support de substrat et/ou dans lequel le transducteur photoélectrique est monté de manière amovible dans ou sur le dispositif portant le transducteur.

5. Dispositif tel que revendiqué dans l'une des revendications précédentes, dans lequel le substrat est agencé sur ou dans une partie centrale du support de substrat, le dispositif portant le transducteur étant relié ou pouvant être relié au support de substrat dans une partie externe ou dans une partie adjacente à la partie centrale du support de substrat.

6. Dispositif tel que revendiqué dans l'une des revendications précédentes, dans lequel le dispositif (3,4) portant le transducteur comprend
a)un support de transducteur (3) dans lequel ou sur lequel le transducteur photoélectrique (20) peut être monté ou est monté, en particulier de manière amovible, et
b)un organe de maintien de support (5) dans ou sur lequel le support de transducteur (3) peut être monté ou est monté, en particulier de manière amovible,
c)dans lequel ledit organe de maintien de support peut être relié ou est relié au support de substrat (17).

7. Dispositif tel que revendiqué dans l'une quelconque des revendications précédentes, dans lequel le dispositif portant le transducteur ou le support de transducteur comprend plusieurs sections de maintien (32, 33, 34) entre lesquelles est placé le transducteur et par lesquelles le transducteur est pratiquement empêché de se déplacer ou de tomber.

8. Dispositif selon l'une quelconque des revendications précédentes, dans lequel le dispositif portant le transducteur ou l'organe de maintien de support comprend une plate-forme de transducteur (54) pour monter le support de transducteur ou le transducteur et une paroi latérale (50) entourant la plate-forme de transducteur et de préférence également le substrat lorsque l'organe de maintien de support ou le dispositif portant le transducteur est monté sur le support de substrat.

9. Dispositif tel que revendiqué dans l'une quelconque des revendications précédentes comprenant en outre un couvercle de dessus (6), monté ou pouvant être monté sur le dispositif de maintien de support et/ou le dispositif portant le transducteur, le couvercle de dessus et l'organe de maintien de support ou le dispositif portant le transducteur formant ensemble respectivement, lorsqu'ils sont montés, un boîtier au moins pour le transducteur photoélectrique ou le support de transducteur avec le transducteur monté et, de préférence, également pour le substrat.

10. Dispositif tel que revendiqué dans la revendication 9, dans lequel le couvercle de dessus est relié ou peut être relié, de préférence de manière non positive, au support de substrat, en particulier au moyen d'au moins une connexion à fiche-trou (6A à 6D, 16A à 16D), et dans lequel le couvercle de dessus fixe de préférence, au support de substrat, l'organe de maintien de support ou le dispositif portant le transducteur.

11. Dispositif tel que revendiqué dans l'une des revendications précédentes, dans lequel, pour un auto-alignement d'au moins une paire des composants à relier, en particulier le dispositif portant le transducteur ou le couvercle de dessus et le support de substrat et le dispositif portant le transducteur et le transducteur photoélectrique, les composants sont munis d'aides de réglage (par exemple, 56 et 61, 57 et 67) et/ou de moyens de liaison d'auto-alignement (par exemple, 6C et 16C).

12. Dispositif tel que revendiqué dans l'une quelconque des revendications précédentes, dans lequel le transducteur photoélectrique est relié optiquement à un guide de lumière (26) qui est de préférence guidé ou peut être guidé à travers au moins un passage ou une ouverture (51,61) formé dans le dispositif portant le transducteur, le support de transducteur, l'organe de maintien de support et/ou le couvercle de dessus.

13. Dispositif tel que revendiqué dans la revendication 12,
dans lequel le couvercle de dessus et le dispositif portant le transducteur ou l'organe de maintien de support comprennent deux sections de découpe correspondantes (51, 61) formant ensemble, lorsqu'elles sont montées, une ouverture pour le guide de lumière.

14. Dispositif tel que revendiqué dans la revendication 12 ou 13, dans lequel, à l'intérieur d'au moins un passage ou d'une ouverture (51, 61) pour le guide de lumière (26), est agencé un palier élastique (70) pour le guide de lumière, en fournissant de préférence un centre de rotation pour le guide de lumière.

15. Dispositif optoélectrique comprenant
a) au moins un transducteur photoélectrique (20) pour convertir des signaux optiques en signaux électriques et/ou des signaux électriques en signaux optiques,
b) un dispositif de traitement de signaux électriques (10) comprenant
b1) un substrat (11) portant des composants et/ou des circuits électroniques (12) pour traitement de signaux électriques et étant relié ou pouvant être relié électriquement au transducteur photoélectrique pour transmettre des signaux électriques depuis le transducteur vers les composants ou les circuits électroniques et/ou depuis les composants ou les circuits électroniques vers le transducteur et
b2) un support de substrat (15) portant le substrat et servant de préférence de dissipateur de chaleur pour le substrat,
et comprenant en outre
d) au moins un dispositif selon l'une quelconque des revendications 1 à 14 pour agencer cet au moins un transducteur photoélectrique (20) dans le dispositif de traitement de signaux électriques (10), dans lequel chaque dispositif (3,5) portant le transducteur porte au moins un transducteur photoélectrique et chaque dispositif portant le transducteur est monté directement sur le support de substrat.

16. Dispositif optoélectrique tel que revendiqué dans la revendication 15, dans lequel le transducteur photoélectrique est relié ou peut être relié à un guide de lumière (26) pour transmettre des signaux optiques devant être convertis ou étant convertis par le dispositif photoélectrique.

17. Dispositif optoélectrique tel que revendiqué dans la revendication 15 ou la revendication 16, dans lequel le dispositif de traitement de signaux électriques comprend un amplificateur électrique (10), en particulier un amplificateur de télévision par câble ou CATV, et dans lequel le support de substrat (17) est de préférence conçu selon la norme internationale SOT115.
